# EUROPEAN PATENT APPLICATION

(11) **EP 1 513 192 A1**
(43) Date of publication of application: **09.03.2005**
(21) Application number: 03733337.4
(22) Date of filing: 10.06.2003
(51) Int. Cl.: H01L 21/02, B24B 9/00

(54) **SEMICONDUCTOR WAFER**

(30) Priority: 13.06.2002 JP 2002173319
(71) Applicant: Shin-Etsu Handotai Co., Ltd, Tokyo 100-0005 (JP)
(72) Inventor: MIYASHITA, Akira, Shin-Etsu Handotai Co., Ltd, Nishihishirakawa-gun, Fukushima 961-8061 (JP); SANUKI, Kouetsu, Shin-Etsu Handotai Co., Ltd., Chiyoda-ku, Tokyo 100-0005 (JP); SATO, Masakazu, Shin-Etsu Handotai Co., Ltd, Nishihishirakawa-gun, Fukushima 961-8061 (JP)
(74) Representative: Cooper, John
(86) International application number: PCT/JP2003/007321
(87) International publication number: WO 2003/107402

(57) **Abstract**

The present invention relates to a semiconductor wafer, wherein the semiconductor wafer has a shape in which the outer peripheral portion of the semiconductor wafer bends in such a manner as to swell (rises) on the wafer front surface and bends in such a manner as to droop (sags) on the wafer back surface. Thus, there is provided a semiconductor wafer capable of forming device patterns on the wafer with high yield despite shape variation in a wafer chuck of an exposure apparatus in the photolithography step and polishing the wafer with uniform stock removal in CMP in a device production process.

## Description

### Technical Field

The present invention relates to a semiconductor wafer typified by silicon wafers, and more particularly to a semiconductor wafer shape.

### Background Art

Prioduction of silicon wafers used as semiconductor substrate material, for example, has been performed in wafer makers. To produce semiconductor wafers, in general, semiconductor single crystal ingots in cylindrical form are grown by the Czochralski (CZ) method, the Floating Zone (FZ) method or other method, and the grown semiconductor single crystal ingots are sliced into wafers in thin plate form, followed by subjecting the obtained wafers to steps such as a chamfering step for chamfering outer peripheral portions of wafers to prevent cracks and chips in wafers, a lapping step for adjusting the wafer thickness and flatness, an etching step for etching wafers to remove mechanical damage from wafers, a polishing step for further improving surface roughness and flatness of etched wafers to make the wafer surfaces into mirror surfaces, and a cleaning step for cleaning wafers to remove polishing agent and foreign substances from wafers. In addition to these semiconductor wafer production steps which is shown as main steps, some other steps such as a heat treatment step may be added, and the sequence of the steps may be altered.

Following production of semiconductor wafers as described above, devices are commonly formed on wafers by device makers to produce semiconductor devices.

In semiconductor device production process, steps in which thin films such as oxide films, metal films or polysilicon films are formed in layers on a semiconductor wafer to form a resist pattern are normally performed about 20 to 30 times, for example. In the case of DRAM (dynamic random access memory), a resist pattern with line width of 0.25µm to 0.20µm is formed on currently mass-produced 64M-bit DRAM. As such thin films are interconnected in a plurality of layers on a semiconductor wafer, unevenness occurs on the layer surfaces, with unevenness growing larger with increasing number of layers laid. To ensure flattening of such interlayer insulator film surfaces, the CMP (Chemical Mechanical Polishing) technique has been proposed as a polishing method for interconnections, etc. In the CMP technique, polishing is performed useing multilayered elastic polishing pads, and therefore uniform stock removal can be obtained.

However, recent years have witnessed significant growth in scale of semiconductor device integration as a result of dramatic advances in semiconductor device technology. This has lead to demands for not only finer circuit patterns but also improved dimensional and alignment precision in circuit patterns. Quality requirements of semiconductor wafers serving as substrates for semiconductor devices are becoming more rigorous in response to such demands. For this reason, it is becoming increasingly difficult to meet flatness specifications needed for the most advanced semiconductor device production using the aforementioned polishing method in conventional semiconductor wafer production. Even if a semiconductor wafer has slight waviness, for example, a device pattern error occurs in the photolithography and other steps, thus resulting in the problem that reduction of yield is caused. Further, the wafer main front surface is now required to be flat up to the proximity of its outermost periphery (proximity of its chamfered portion) for the purpose of making effective use of semiconductor wafers and thereby achieving improved productivity.

To produce such semiconductor wafers having high flatness, wafer makers are applying a variety of engineering improvements. For instance, to give wafers a mirror-polished finish with a given surface roughness while maintaining the obtained flatness following flattening to a high degree through polishing and surface grinding, the aforementioned CMP technique - the technique that provides uniform stock removal - is used in the polishing step, thus performing a smooth and damage-free mirror-polishing. The CMP technique is designed on the principle of achieving polishing by chemical and mechanical effects, and, for example, polishing is conducted by rubbing a wafer and a polishing pad relatively to each other under a given load while supplying a polishing agent in which colloidal silica is dispersed in alkali solution. In such a mirror polishing of wafers by the CMP technique, a soft silica hydrate film is formed on the wafer surface by the alkali solution, and polishing proceeds as this hydrate film is removed.

Further, there is a recent trend in production of highly flat semiconductor wafers to polish both the front and back surfaces of wafers. In order to flatten a semiconductor wafer up to the proximity of the outermost periphery (proximity of the chamfered portion), polishing is conducted more often by a CMP polishing apparatus with a polishing head using a retainer ring that pushes in the polishing pad at the wafer periphery for preventing excessive polishing of the outer peripheral portion to prevent peripheral sag.

In the case of producing semiconductor wafers by the polishing described above, as long as the design rule of the device production process was up to 0.18µm, it has been possible to obtain semiconductor wafers of sufficient quality by producing semiconductor wafers so as to meet the semiconductor wafer flatness standard using conventional indicators such as GBIR (Global Back Ideal Range), SBIR (Site Back Ideal Range) and SFQR (Site Front least-squares Range).

However, the higher integration degree of semiconductor device in recent years has pushed the design rule down to 0.15µm and further to 0.13µm for stricter specification. As a result, even if the semiconductor wafer has met the flatness standard as described above, a resist pattern could not be formed precisely when the device had been actually fabricated on the wafer, and therefore, the problem that reduction of yield is caused occurred.

In particular, while GBIR, SBIR and SFQR are able to ensure high precision in flatness evaluation at the wafer center, these indicators fail to accurately evaluate the wafer shape at the wafer outer periphery, and particularly near the boundary between the main surface and the chamfered portion of the wafer. For this reason, lower yield has resulted even when the semiconductor wafer flatness met the standard according to the aforementioned indicators. For example, a number of exposure apparatuses, processing apparatuses in CMP and the like are employed for the device production process, and the steps in which treatments are performed using such apparatuses have experienced worsening yield at increasingly frequent occasions.

It is considered that one of the possible contributors to such aggravated yield is compatibility between a wafer holding chuck used in an exposure apparatus of a photolithography step and wafer shape. As for such compatibility between wafer chuck and wafer shape, matching between a shape of the wafer chuck and a shape of outer peripheral portion of the wafer, etc. is important. For example, if wafer chuck shape matches poorly with the shape of outer peripheral portion of the wafer, defocus takes place during resist pattern transfer onto the wafer surface, thus resulting in reduced yield. Therefore, production of semiconductor wafers well compatible with wafer holding chuck is demanded.

However, matching between a shape of a wafer chuck and shape of outer peripheral portion of a wafer is an issue addressed by device makers, and it is impossible to perform accurate confirmation thereof by wafer makers. Therefore, the wafer makers are facing growing needs to supply to device makers wafers having a shape that does not affect yield even in the event of variation in chuck shape to a certain extent.

Uniformity of stock removal in a wafer plane is essential in polishing using CMP, etc. in the device production process. However, in conventional semiconductor wafer production, since outer peripheral shape of a wafer can not be evaluated precisely as described above, it is impossible to ensure high precision in shape control of the wafer outer peripheral portion. Therefore, when CMP is performed using the retainer ring in the device step, in the case that a semiconductor wafer has a sagging shape at the outer peripheral portion, non-polishing occurs and stock removal is reduced. When CMP is performed on a wafer flat to the outer periphery, polishing in itself tends to readily process the wafer to have a rising shape, resulting in variation in stock removal. As a result, non-uniformity of film thickness and discoloration is caused, resulting in reduced yield.

In conventional semiconductor wafers, further, if a wafer is polished on both front and back surfaces by the CMP polishing apparatus having a polishing head using the retainer ring, etc. in the polishing step during the wafer production, the both front and back surfaces of the wafer become a rising shape at the outer peripheral portions. On the other hand, even if no retainer ring is used in the polishing step, the both front and back surfaces of the wafer often become a sagging shape at the outer peripheral portions due to etching effect and so on. That is, conventional semiconductor wafers have had a similar shape on both front and back surfaces although there is a slight difference in extent of rise and sag.

For this reason, if a semiconductor wafer has a preferred shape for exposure apparatus used in the photolithography step during semiconductor device production, performing CMP on the semiconductor wafer leads to worsening stock removal uniformity. Conversely, a semiconductor wafer having a preferred shape for CMP is poorly compatible with exposure apparatus, resulting in a problem that reduction of yield is caused. That is, conventional semiconductor wafers could not be shaped suitably for both steps.

### Disclosure of the Invention

The present invention was accomplished in light of the foregoing, and it is an object of the present invention to provide a semiconductor wafer capable of forming device patterns on the wafer with high yield despite shape variation in a wafer chuck of an exposure apparatus in the photolithography step and polishing the wafer with uniform stock removal in CMP in a device production process.

In order to achieve the above object, according to the present invention there is provided a semiconductor wafer, wherein the semiconductor wafer has a shape in which the outer peripheral portion of the semiconductor wafer bends in such a manner as to swell (rises) on the wafer front surface and bends in such a manner as to droop (sags) on the wafer back surface.

Thus, it is possible to ensure that the semiconductor wafer constitutes not only a preferred wafer for a variety of exposure apparatuses used commonly for the photolithography step but also a wafer capable of performing CMP with uniform stock removal, if the outer peripheral portion thereof bends in such a manner as to swell (rises) on the wafer front surface and bends in such a manner as to droop (sags) on the wafer back surface. As used herein, the wafer front surface refers to one of the wafer main surfaces - the surface on which devices, etc. are formed - and the wafer back surface to the other wafer main surface.

In this event, the bend of the outer peripheral portion of the semiconductor wafer is preferably such that, when performing measurement of shape data on the front and back surfaces of the semiconductor wafer, creation of respective shape profiles along the radial direction from the measured shape data on the front and back surfaces of the wafer and calculation of differential profiles through differential processing of the created respective shape profiles, the differential profile of the wafer front surface exhibits a bend like swelling (rise) at the outer peripheral portion and the differential profile of the wafer back surface exhibits a bend like drooping (sag) at the outer peripheral portion.

Thus, as for bend of outer peripheral portion of the semiconductor wafer, if, when performing measurement of shape data on both front and back surfaces of a semiconductor wafer, creation of shape profiles along the radial direction from the measured shape data on the front and back surfaces of the semiconductor wafer and calculation of differential profiles through differential processing of the respective created shape profiles, the differential profile of the wafer front surface exhibits a bend like swelling (rise) at the outer peripheral portion - that is, the differential value of the differential profile (magnitude of slope µm/mm) changes on the positive side when rise is expressed as positive - and if the differential profile of the wafer back surface exhibits a bend like drooping (sag) at the peripheral portion - that is, the differential value of the differential profile (magnitude of slope µm/mm) changes on the negative side when sag is expressed as negative, then it is possible to make a semiconductor wafer having different shapes between the front and back surfaces which could not be confirmed accurately by the conventional indicators based on wafer thickness into a quantitatively and accurately prescribed wafer. It is possible to reliably ensure, therefore, that such a semiconductor wafer is a wafer that is preferred for exposure apparatus used in the photolithography step and capable of performing CMP with uniform stock removal.

It is preferred that the front and back surfaces of the semiconductor wafer bend in a region of the outer peripheral portion excluding 1mm to 2mm from the outermost periphery of the semiconductor wafer.

For semiconductor wafers, the shape of the outer peripheral portion in the region where devices are actually formed is important. The area (specification) guaranteed for flatness in wafers supplied to the device production process has conventionally often been the area excluding 3mm from the outermost peripheral portion of the wafers (the region toward the center of wafers excluding this portion is occasionally referred to as wafer effective region). It is preferred, therefore, that the shape of the wafer according to the present invention is at least such that the outer peripheral portion in the wafer effective region bends in such a manner as to swell (rises) on the wafer front surface and bends in such a manner as to droop (sags) on the wafer back surface. In particular, it is preferred that, even if the guaranteed area is the area excluding 3mm from the outermost peripheral portion of the wafer, bend occurs up to the region of the outer peripheral portion excluding 2mm from the outermost periphery (end portion) of the semiconductor wafer and further up to the region excluding 1mm from the outermost periphery (end portion). If the semiconductor wafer is formed to have a bend occurring up to such a region, it is possible to considerably reduce generation of defocus failure, discoloration failure due to CMP and the like within the guaranteed area. Further, it is also possible to address changes in guaranteed area (specification) of wafer flatness into a region excluding 2mm or 1mm from the outermost periphery of the wafer. In general, since a chamfered portion is formed on the outermost periphery of the semiconductor wafer, it is preferred that a bend occurs in the region of the outer peripheral portion excluding 1mm or less from the outermost periphery of the semiconductor wafer on both front and back surfaces. This ensures that the semiconductor wafer constitutes a preferred wafer for both exposure apparatuses used in the photolithography step and for polishing by CMP.

It is preferred that the rise start position on the front surface (turning point on the front surface) and the sag start position on the back surface (turning point on the back surface) at the outer peripheral portion of the semiconductor wafer lie in a region within 10mm from the outermost periphery of the wafer.

To improve compatibility with exposure apparatus in the photolithography step and uniformity of stock removal in polishing by CMP, the wafer shape at the outer peripheral portion and particularly in the region within 10mm from the wafer outermost periphery is extremely important. Consequently, the semiconductor wafer can constitute a preferred wafer for both exposure apparatus used in the photolithography step and for polishing by CMP, if the rise start position on the front surface (turning point on the front surface) and the sag start position on the back surface (turning point on the back surface) at the outer peripheral portion of the semiconductor wafer lie in a region within 10mm from the outermost periphery of the wafer as in the present invention.

At that time, the rise start position on the front surface (turning point on the front surface) and the sag start position on the back surface (turning point on the back surface) of the semiconductor wafer are preferably located at the same distance from the wafer center along the wafer radial direction.

Thus, if the turning points on the front and back surfaces of the semiconductor wafer are located at the same distance from the wafer center along the wafer radial direction, it is possible to ensure a semiconductor wafer having approximately uniform thickness at the device fabrication region in the wafer plane, despite different shapes on the front and back surfaces of the semiconductor wafer. Consequently, since the semiconductor wafer front surface can be kept in a flat state by vacuum absorption of the wafer using a vacuum chuck in the photolithography step, for example, it is possible to accurately form patterns on the wafer front surface.

The front and back surfaces of the semiconductor wafer are preferably mirror-polished.

Thus, the semiconductor wafer can be have higher flatness if the front and back surfaces thereof are mirror-polished. Therefore, it is possible to fabricate devices with high precision on the semiconductor wafer, further improving yield in device production.

As described above, it is possible according to the present invention to provide a semiconductor wafer that is preferred for exposure apparatus commonly used in the photolithography step and that has a shape capable of performing CMP with uniform stock removal. Such a semiconductor wafer according to the present invention allows accurate formation of device patterns on the wafer front surface while remaining free of uneven film thickness and discoloration even in performing CMP in the device production process, and therefore yield in semiconductor device production can be improved.

### Brief Explanation of the Drawings

Fig. 1 is a schematic explanatory view showing in diagrammatic form the shape of a semiconductor wafer of the present invention;
Fig. 2 is a graph showing shape profiles in the area of 120 to 148mm from the center along the radial direction of a semiconductor wafer;
Fig. 3 is a graph showing differential profiles calculated by subjecting the shape profiles of Fig. 2 to a differential processing;
Fig. 4 is an explanatory view showing in diagrammatic form the state in which the semiconductor wafer of the present invention is placed on a wafer chuck of an exposure apparatus;
Fig. 5 is an explanatory view showing in diagrammatic form the state in which the semiconductor wafer of the present invention is subjected to CMP;
Fig. 6 is a schematic explanatory view showing an example of shape measurement means for measuring shape data of a semiconductor wafer; and
Fig. 7 is an explanatory view describing shape, data measurement on the wafer front and back surfaces using displacement gauges in the shape measurement means of Fig 6.

### Best Mode for Carrying out the Invention

Although an embodiment of the present invention will be described below, it is to be understood that the present invention is not limited thereto.

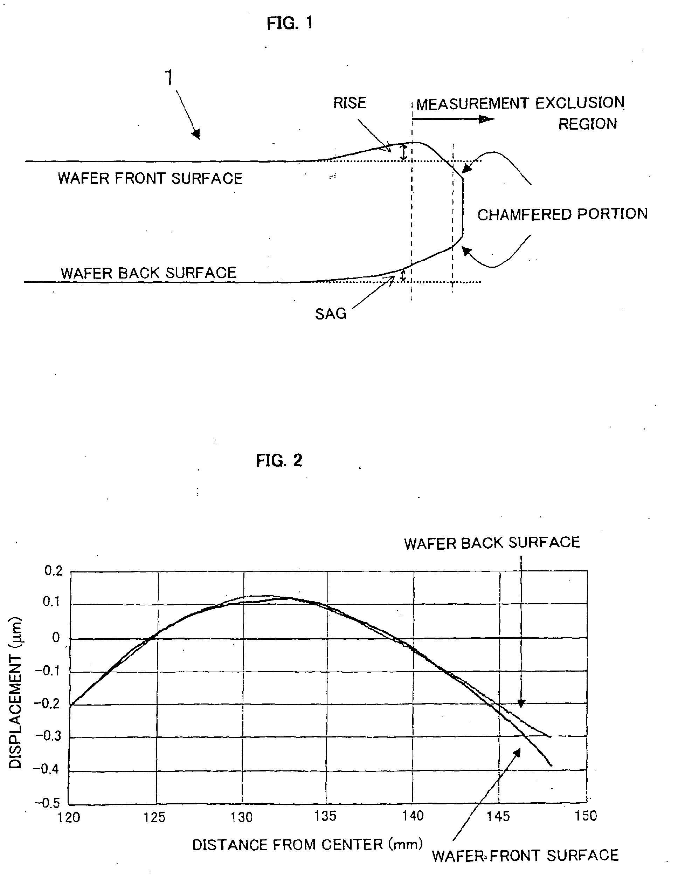

Fig. 1 illustrates a schematic explanatory view describing the shape of a semiconductor wafer of the present invention. Fig. 1 shows the features of the present invention in exaggerated fashion for clarity of presentation, and proportionality relation of the sizes and figures and so on are different from an actual wafer. The present invention is in no way limited thereby.

As shown in Fig. 1, a semiconductor wafer 1 of the present invention is characterized in that the wafer has a shape in which the outer peripheral portion of the semiconductor wafer bends in such a manner as to swell (rises) on the wafer front surface and bends in such a manner as to droop (sags) on the wafer back surface.

That is, the semiconductor wafer of the present invention has different shapes between on the front and back surfaces, with the wafer outer peripheral portion bending on the wafer front surface so as to be more convex than the wafer surface position at the center portion of the front surface (this bend is referred to as "rise") and bending on the wafer back surface so as to be more concave than the wafer surface position at the center portion of the back surface (this bend is referred to as "sag").

Although confirmation of the shape of the outer peripheral portion is easy if the wafer main surface is of ideal shape having flat surface but no waviness, it is actually impossible to accurately evaluate the outer peripheral shape due to waviness and other causes. For this reason, the semiconductor wafer of the present invention is a wafer in which when subjected to measurement of shape data on both front and back surfaces of the semiconductor wafer, creation of shape profiles along the radial direction from the measured shape data of the front and back surfaces of the wafer, and calculation of differential profiles through differential processing of the respective created shape profiles, the differential profile of the wafer front surface exhibits a bend like swelling (rise) at the outer peripheral portion, and the differential profile of the wafer back surface exhibits a bend like drooping (sag) at the outer peripheral portion.

Thus, the semiconductor wafer having different shapes between the front and back surfaces can be quantitatively expressed if the semiconductor wafer shape is prescribed by the aforementioned method, that is, the differential type shape evaluation system. Therefore, the semiconductor wafer can reliably have a shape such that rise is formed on the front surface and sag is formed on the back surface. The method will be described below for prescribing the shape of the semiconductor wafer of the present invention by the differential type shape evaluation system with reference to the accompanying drawings.

First, shape data of the front and back surfaces of the semiconductor wafer is measured.

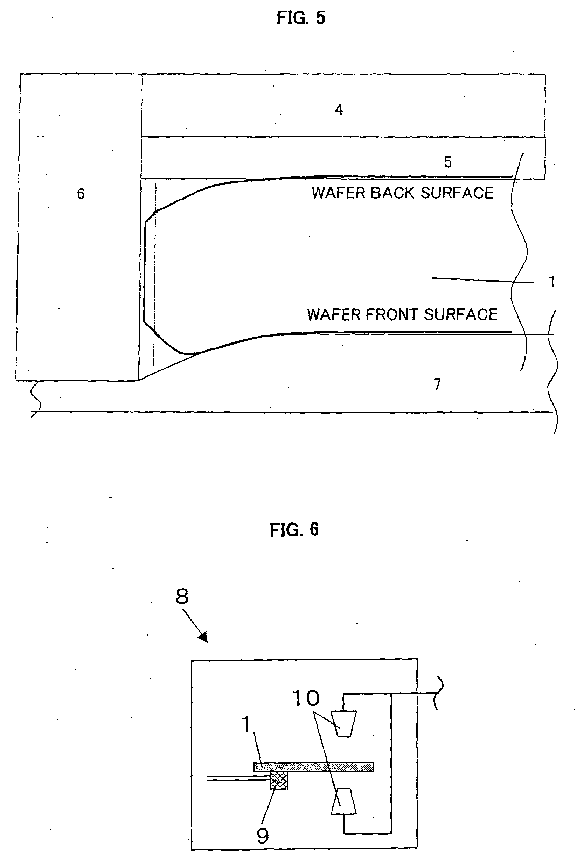

Shape data measurement of the semiconductor wafer can be conducted, for example, using shape measurement means 8 shown in Fig. 6. Shape data of the front and back surfaces of the semiconductor wafer 1 can be obtained by holding part of the outer peripheral portion or the main surface of the semiconductor wafer by a wafer holder 9, scanning the semiconductor wafer with two displacement gauges 10 of front and back arranged so as to sandwich the wafer 1 and thereby measuring the displacement of surface along the wafer thickness direction.

At this time, as for the shape data of the semiconductor wafer, the shape of the semiconductor wafer can be evaluated with excellent precision by scanning the front and back surfaces of the semiconductor wafer at fine measurement intervals. For instance, it is possible to measure the shape data of the semiconductor wafer with excellent measurement precision by setting the semiconductor wafer scanning intervals to 1mm or less and particularly about 0.05mm.

As alternative methods for measuring the shape data of the semiconductor wafer, the shape data is obtained by placing a semiconductor wafer without absorption on the specimen table for holding a target to be measured, scanning the front or back surface of the semiconductor wafer with a displacement gauge and measuring the displacement of surface along the wafer thickness direction, for example.

Further, it is possible to more accurately prescribe the shape of the semiconductor wafer by obtaining thickness data through the measurement of the semiconductor wafer thickness concurrently with obtaining the shape data of the semiconductor wafer.

Next, shape profiles along the radial direction are created respectively for the front and back surfaces of the semiconductor wafer from the measured shape data of the front and back surfaces of the semiconductor wafer.

When the wafer shape at the outer peripheral portion which is the feature of the semiconductor wafer of the present invention is prescribed, for example, shape profiles of the wafer outer peripheral portion as shown in Fig. 2 are created. The shape profiles of Fig. 2 show data of the shape in the region of 120 to 148mm from the wafer center of the semiconductor wafer having a diameter of 300mm. At this time, the region of 2mm from the outermost periphery of the wafer was excluded from measurement. As is apparent from the figure, mere observation of the shape profile (displacement) does not lead to an accurate judgment as to whether the outer peripheral shape becomes sag or rise and where the shape change begins because of considerable effects of waviness, etc.

Since the outer peripheral portion of the semiconductor wafers has generally been subjected to chamfering for preventing chips of the wafer and the like, a chamfered portion is formed as shown in Fig. 1. The width of the chamfered portion varies depending on the wafer production method but is normally about 500µm (0.5mm). Considering factors such as measurement precision, it suffices to exclude the region of 1mm from the outermost periphery of the semiconductor wafer including the chamfered portion. Further, the region toward the center of the wafer excluding the region within 1mm to 2mm from the wafer outer periphery is of prime importance in the semiconductor wafer of the present invention. That is, it is possible to ensure that the semiconductor wafer of the present invention constitutes a preferred wafer for exposure apparatus used in the photolithography step and for performing CMP, if the front and back surfaces of the semiconductor wafer of the present invention has a bend in a region excluding the measurement exclusion region within 1mm to 2mm from the outermost periphery of the semiconductor wafer including the chamfered portion.

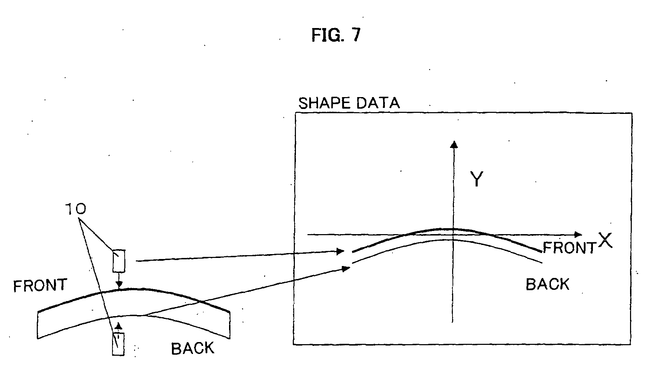

At this time, either sign (positive or negative) can be chosen at will to express shape profile (shape data). It suffices to ensure that the direction of rise or sag of the wafer surface in the outer peripheral portion of the wafer is not wrong when the wafer shape is prescribed. In the present case, for example, since the shape data of the semiconductor wafer is measured using the shape measurement means 8 shown in Fig. 6, the shape data is obtained by the displacement gauges 10 as shown in Fig. 7. Therefore, the shape data of the wafer back surface is represented with the opposite sign in terms of positive and negative to that used in the shape data of the wafer front surface.

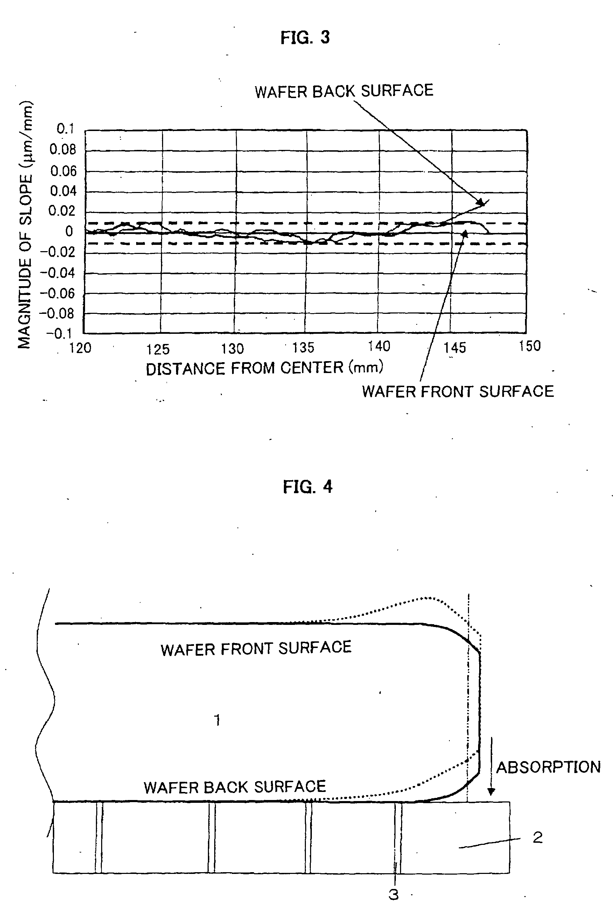

Next, the created shape profiles (Fig. 2) are differentiated with respect to an arbitrary position at constant intervals. Then, by plotting data at the midpoint thereof, differential profiles can be calculated as shown in Fig. 3. That is, as the basis for an arbitrary point Xᵢ (mm) in the created shape profiles, it is possible to calculate differential profiles by calculating the quotient of the difference between a magnitude of displacement of the shape profile Yᵢ₊₁ (µm) at Xᵢ₊₁ (mm) and a magnitude of displacement of the shape profile Yᵢ (µm) at Xᵢ (mm) divided by a constant interval (Xᵢ₊₁ - Xᵢ) as a differential value (dyi), and then plotting the data at the midpoint of the interval (Xᵢ₊₁ - Xᵢ) . The differential value corresponds to a magnitude of slope (µm/mm).

The differential profiles in Fig. 3 are obtained by subjecting to least square approximation for removing the long wavelength component and also performing an operation of moving average of about 1 to 2mm for removing measurement noises during calculation of differential profiles from the shape profiles. Thus, by removing the long wavelength component such as warp and measurement noises to a certain extent, local changes in wafer shape can be measured accurately.

At this time, while the interval (Xᵢ₊₁ - Xᵢ) for which differentiation of the shape profile is performed can be selected arbitrarily according to the shape of the semiconductor wafer to be evaluated, if the shape profiles are subjected to differentiation at 1mm-intervals along the wafer radial direction, the shape of the semiconductor wafer can be prescribed with high precision.

The semiconductor wafer of the present invention is a wafer in which the differential profile thus obtained exhibits a bend like swelling (rise) on the outer peripheral portion of the wafer front surface - that is, the differential value of the differential profile (magnitude of slope µm/mm) changes on the positive side when rise is expressed as positive - and exhibits a bend like drooping (sag) on the outer peripheral portion of the wafer back surface - that is, the differential value of the differential profile (magnitude of slope µm/mm) changes on the negative side when sag is expressed as negative.

That is, the semiconductor wafer of the present invention has a shape in which the differential profile of the wafer front surface shows positive within the evaluation region at the outer peripheral portion as in the differential profile shown in Fig. 3, for example, if the wafer surface slope in the direction of increasing wafer thickness on the wafer front surface is expressed as positive. On the other hand, the semiconductor wafer of the present invention has a shape in which the differential profile of the wafer back surface shows positive within the evaluation region at the outer peripheral portion, for example, if the wafer surface slope in the direction of decreasing wafer thickness on the wafer back surface is expressed as positive.

Thus, by prescribing the shape of the semiconductor wafer according to the differential type shape evaluation system, it is possible to quantitatively and accurately indicate the shape of the semiconductor wafer as in the present invention, which has been not confirmed accurately by the conventional evaluation of the semiconductor wafer based on wafer thickness, that is, shape in which rise is formed on the front surface and sag is formed on the back surface of the wafer outer peripheral portion. Therefore, it is possible to accurately and clearly define the wafer shape by prescribing the shape of the wafer outer peripheral portion using the evaluation method.

At this time, it is sufficient that the semiconductor wafer of the present invention bends in the region of the outer peripheral portion excluding the measurement exclusion region which is within 1mm to 2mm from the outermost periphery of the semiconductor wafer on the front and back surfaces of the wafer as shown in Fig. 1, and the shape of the semiconductor wafer in the measurement exclusion region can be arbitrary.

Therefore, for example, a wafer shape in the measurement exclusion region on the wafer front surface may be a shape in which rise changes gradually into sag and the sag is formed as far as to the chamfered portion. That is, the bending in such a manner as to swell on the wafer front surface in the present invention means that the outer peripheral portion on the wafer front surface results in a bending shape (rising shape) so as to be more convex than the wafer surface position at the center portion of the front surface as described above, and since it is only natural that the outer peripheral portion eventually connects to the chamfered portion, this does not mean that there are no sags at all on the surface of the outer peripheral portion. While the wafer shape in the measurement exclusion region of the wafer back surface can be also chosen arbitrarily, it is preferred that the measurement exclusion region of the wafer back surface takes the shape that continues to be sag to the chamfered portion and be free of rise as shown in Fig.1.

The semiconductor wafer of the present invention having the shape as described above can be a wafer that is preferred for a variety of exposure apparatuses commonly used in the photolithography step and is capable of performing CMP with uniform stock removal.

Fig. 4 shows in diagrammatic form the state in which the semiconductor wafer of the present invention is placed on a wafer chuck (vacuum chuck) of an exposure apparatus, and Fig. 5 shows in diagrammatic form the state in which the semiconductor wafer of the present invention is subjected to CMP.

As shown in Fig. 4, when the semiconductor wafer of the present invention undergoes the photolithography step, the back surface of the semiconductor wafer 1 is intentionally held on a absorption chuck 2 by vacuum absorption of the back surface of the semiconductor wafer 1 with absorption chuck 2 having penetrating holes 3, thus causing the rising portion at the outer peripheral portion of the wafer front surface to become flat. Thereby, when resist patterns transfer onto the wafer front surface, defocus at the wafer outer peripheral portion is hard to be caused, so that a yield in device production can be improved. Moreover, a wafer having the shape of the present invention allows flattening of the wafer surface after absorption to the peripheral area even if variation in a wafer chuck shape is generated between apparatuses such as exposure apparatuses, thus preventing reduced device yield.

When the semiconductor wafer of the present invention is subjected to CMP in the device productioln step, the back surface of the semiconductor wafer 1 is held by a polishing head 4 having a retainer ring 6 via a packing pad 5, and the wafer front surface is brought into contact with a polishing pad 7 as shown in Fig. 5. At this time, the polishing pad 7 is put into a state in which the retainer ring 6 presses it. For this reason, by performing CMP under this condition, the outer peripheral portion of the front surface of the semiconductor wafer 1 is polished into a shape modeled after the rising shape, and therefore, the wafer can be polished with uniform stock removal in a wafer plane. As a result, a variation in stock removal is not caused and non-uniformity in film thickness and discoloration are prevented, suppressing reduced yield in the device production step.

Thus, it is possible to ensure that the semiconductor wafer of the present invention is well compatible with a wafer chuck of an exposure apparatus and capable of polishing uniformly during CMP.

At this time, in order to reliably ensure good compatibility between exposure apparatus in the photolithography step and the semiconductor wafer and improve uniformity in stock removal of the wafer in CMP, it is extremely important that the wafer shape at the outer peripheral portion, in particularly, in the region within 10mm from the wafer outermost periphery is controlled precisely. Therefore, it is preferred that at the outer peripheral portion of the semiconductor wafer, the rise start position where bend begins on the wafer front surface (turning point on the front surface) and the sag start position where bend begins on the wafer back surface (turning point on the back surface) is located in a region within 10mm from the outermost periphery of the wafer.

At this time, if the rise start position on the front surface (turning point on the front surface) and the sag start position on the back surface (turning point on the back surface) of the semiconductor wafer are located at the same distance from the wafer center along the wafer radial direction, the semiconductor wafer can have a uniform thickness in the wafer plane even in the case of a semiconductor wafer having different shapes between the front and back surfaces as in the present invention. Therefore, when the semiconductor wafer 1 is held by vacuum absorption using the absorption chuck 2 in the photolithography step for example as shown in Fig. 4, the front surface of the semiconductor wafer can be flattened to the proximity of the measurement exclusion region, and therefore, resist patterns can be formed accurately to the proximity of the measurement exclusion region on the wafer surface.

Further, it is preferred that the semiconductor wafer of the present invention is mirror-polished on the front and back surfaces of the wafer. If the semiconductor wafer of the present invention is mirror-polished on the both surfaces, it is possible to ensure high level of flatness in the semiconductor wafer. Therefore, devices can be formed accurately on the wafer front surface even in the event of more rigorous design rule introduced in the device production process, so that yield in the device production process can be improved further.

It is to be understood that, in the semiconductor wafer of the present invention, the magnitudes of slopes of the rise on the front surface and the sag on the back surface at the wafer outer peripheral portion are not specifically limited, and the magnitude of slope of the sag on the back surface, for example, may be determined as appropriate according to the intensity of vacuum absorption and the shape of the wafer chuck in the exposure apparatus and others. As for the magnitude of slope of the rise on the front surface, it may be determined the magnitude as appropriate according to a setting condition of the retainer ring and a polishing condition in CMP. Thus, it is possible to improve further yield in the device production process by determining as appropriate the magnitudes of slopes of the rise on the front surface and the sag on the back surface at the wafer outer peripheral portion according to the device production conditions.

Further, the method for producing the semiconductor wafer of the present invention is not specifically limited. That is, any methods can be used as long as a semiconductor wafer can be produced whose outer peripheral portion has a rising shape on the wafer front surface and a sagging shape on the wafer back surface. For example, as an example of method for producing the semiconductor wafer of the present invention, there is a method in which semiconductor wafers are processed by subjecting to plasma etching.

More specifically, a silicon single crystal is pulled by the CZ method first, and the obtained single crystal is sliced, and then subjected to the chamfering, lapping, etching and mirror polishing steps in succession to manufacture semiconductor wafers. After that, the front and back surfaces of the obtained semiconductor wafer are respectively evaluated for shape by the differential type shape evaluation system. From the evaluation results, the etching area and etching amount for plasma etching are calculated respectively for the wafer front and back surfaces. Then, based on the calculated etching area and etching amount, the front and back surfaces of the semiconductor wafer is separately subjected to plasma etching by irradiating raw material gas in plasma form onto the semiconductor wafer. By using such a method, it is possible to accurately produce the semiconductor wafer of the present invention having a shape in which rise is formed on the front surface and sag is formed on the back surface.

As an alternative method, when a semiconductor wafer is produced, new steps such as etching, lapping and further surface grinding may be added to perform a processing of the wafer so as to provide the wafer shape of the present invention.

The present invention will be explained specifically hereafter with the Examples of the present invention. However, the present invention is not limited to these.

### (Example)

A silicon single crystal having diameter of 300mm was pulled by the CZ method, and the obtained single crystal was sliced, followed by subjecting to steps of chamfering, lapping, etching and mirror polishing in succession to manufacture a silicon wafer. At this time, the front and back surfaces of the wafer were polished by CMP using the retainer ring in the mirror-polishing step. It is found that the silicon wafer after the mirror-polishing step has the approximately same shape in the front and back surfaces such that rise is formed at the outer peripheral portion on both of the front and back surfaces.

Next, the front and back surfaces of the obtained silicon wafer were respectively evaluated by the differential type shape evaluation system. Then, from the evaluation results, the etching area and etching amount were calculated respectively for the wafer front and back surfaces to be subjected to plasma etching so that the silicon wafer may have a shape in which rise is formed on the front surface and sag is formed on the back surface at the wafer outer peripheral portion (while the front surface does not need plasma etching since the peripheral area on the front surface already has rise as described above, both of the front and back surfaces are subjected to plasma etching in order to control the shape of the front and back surfaces with high precision.)

Then, based on the respective etching areas and etching amounts calculated for the wafer front and back surfaces, the semiconductor wafer is subjected to plasma etching by irradiating a raw material gas in plasma form thereto to manufacture a silicon wafer.

After the manufacturing of the silicon wafer as described above, shape data of the front and back surfaces of the obtained silicon wafer was measured using Nanometro (registered trademark) 300TT (manufactured by KURODA PRECISION INDUSTRIES LTD.) which is a measuring device of non-contact laser displacement gauges (two-head type). Next, shape profiles were created respectively for 120 to 148mm from the wafer center along the radial direction from the measured shape data of the wafer front and back surfaces. Fig. 2 shows shape profiles created for the wafer front and back surfaces.

Next, measurement noises were removed by subjecting the shape profiles of the wafer front and back surfaces of Fig. 2 to a moving average of 2mm, followed by calculation of differential profiles by a differential processing at 1mm-intervals. Then, the long wavelength component was removed by least square approximation, thus calculating differential profiles of the wafer front and back surfaces as shown in Fig. 3.

The differential profiles of the wafer front and back surfaces of Fig. 3 indicate that in the region outside of the distance of 140mm from the wafer center (region of 10mm from the wafer outermost periphery), the differential profile of the wafer front surface remains on the positive side (rising direction), and the differential profile of the wafer back surface also remains on the positive side (sagging direction: it actually remains on the negative side since the sign is reversed for the shape data of the back surface). From the finding, it is apparent that the silicon wafer manufactured by plasma etching has a shape in which rise is formed on the wafer front surface and sag is formed on the wafer back surface at the outer peripheral portion of the wafer.

The rise and sag start positions (turning points on the front and back surfaces) and the magnitudes of slopes of the silicon wafer were also determined from the calculated differential profiles (Fig. 3). As a result, the rise start position on the wafer front surface (turning point on the front surface) was found to be located at a position of 141.1mm from the wafer center, and the sag start point on the back surface (turning point on the back surface) at a position of 140.8mm from the wafer center, indicating that the turning points on the front and back surfaces are located approximately at the same distance from the wafer center. It is also found that the magnitude of slope of the rise on the front surface of the silicon wafer was 0.01µm/mm at a position of 147mm from the wafer center, and the magnitude of slope of the sag on the back surface of the wafer was 0.03µm/mm at a position of 147mm from the wafer center.

Then, 50 silicon wafers having the aforementioned shape were manufactured.

Next, devices were formed with design rule of 0.15µm on the silicon wafer front surfaces by repeatedly subjecting all the manufactured silicon wafers to the photolithography step and the polishing step of CMP in sequence. As a result, in the photolithography step, reduction of yield due to defocus was considerably diminished. Also in the polishing step of CMP, discoloration failure caused by non-uniformity of film thickness diminished. And, it was discovered that the shape of the wafers resulted in only minor yield reduction even when a plurality of exposure apparatuses and CMP were used and'kept the yield unaffected even in the event of variation to a certain extent between apparatuses, and therefore, highly integrated devices can be produced with high yield.

The present invention is not limited to the embodiments described above. The above-described embodiments are mere examples, and those having the substantially same structure as that described in the appended claims and providing the similar functions and advantages are included in the scope of the present invention.

## Claims

1. A semiconductor wafer, wherein the semiconductor wafer has a shape in which the outer peripheral portion of the semiconductor wafer bends in such a manner as to swell (rises) on the wafer front surface and bends in such a manner as to droop (sags) on the wafer back surface.

2. The semiconductor wafer according to claim 1, wherein the bend of the outer peripheral portion of the semiconductor wafer is such that, when performing measurement of shape data on the front and back surfaces of the semiconductor wafer, creation of respective shape profiles along the radial direction from the measured shape data on the front and back surfaces of the wafer and calculation of differential profiles through differential processing of the created respective shape profiles, the differential profile of the wafer front surface exhibits a bend like swelling (rise) at the outer peripheral portion and the differential profile of the wafer back surface exhibits a bend like drooping (sag) at the outer peripheral portion.

3. The semiconductor wafer according to claim 1 or claim 2, wherein the front and back surfaces of the semiconductor wafer bend in a region of the outer peripheral portion excluding 1mm to 2mm from the outermost periphery of the semiconductor wafer.

4. The semiconductor wafer according to any one of claims 1 to 3, wherein the rise start position on the front surface (turning point on the front surface) and the sag start position on the back surface (turning point on the back surface) at the outer peripheral portion of the semiconductor wafer lie in a region within 10mm from the outermost periphery of the wafer.

5. The semiconductor wafer according to any one of claims 1 to 4, wherein the rise start position on the front surface (turning point on the front surface) and the sag start position on the back surface (turning point on the back surface) of the semiconductor wafer are located at the same distance from the wafer center along the wafer radial direction.

6. The semiconductor wafer according to any one of claims 1 to 5, wherein the front and back surfaces of the semiconductor wafer are mirror-polished.
